# EUROPEAN PATENT APPLICATION

(11) **EP 4 687 172 A1**
(43) Date of publication of application: **04.02.2026**
(21) Application number: 25157982.7
(22) Date of filing: 14.02.2025
(51) Int. Cl.: H01L 21/67, H01L 21/68, H01L 21/687

(54) **WAFER ALIGNER**

(30) Priority: 02.08.2024 TW 113208298 U
(71) Applicant: Sanwa Engineering Corp., Qionglin Township, Hsinchu 307409 (TW)
(72) Inventor: HSIAO, Ching-Yu, 307409 Qionglin Township, Hsinchu (TW); CHEN, Po-Yen, 307409 Qionglin Township, Hsinchu (TW)
(74) Representative: Schmidbauer, Andreas Konrad

(57) **Abstract**

Disclosed is a wafer aligner (100) including a platform (110), a lifting gripper (120) disposed on the platform (110) to be lifted up or lowered down relative to the platform (110), a rotating gripper (130) disposed on the platform (110) to be rotated relative to the platform (110), a rangefinder (140) disposed next to the platform (110), and a control module (CM). The control module (CM) is electrically connected to the lifting gripper (120), the rotating gripper (130), and the rangefinder (140). The control module (CM) drives the lifting gripper (120) to be lifted up or lowered down to transfer a wafer (200) between the lifting gripper (120) and the rotating gripper (130). The control module (CM) rotates the rotating gripper (130) relative to the platform (110) and drives the rangefinder (140) to detect a change in a relative distance along an edge of the wafer (200).

## Description

### BACKGROUND

### Technical Field

The disclosure relates to a semiconductor device, and in particular to a wafer aligner.

### Description of Related Art

With the advancement of science and technology and the improvement in the standard of living, semiconductor electronic products have been widely used in various fields of society and life, and become an indispensable part in modern life. Before the semiconductor wafer enters the process device, the wafer needs to be positioned, so that the preset notch of the wafer faces a specific position to facilitate subsequent processing of the wafer after positioning.

Specifically, the general wafer positioning method is placing the wafer on the pallet by a robotic arm. A controller controls the rotation of the pallet and detects the notch of the wafer by a sensor to quickly position and calibrate the center of the wafer. In the existing technology, the notch is determined by a comparison sensor. However, when the wafer is in an uncalibrated state to be moved to the device and is grabbed by the gripper of the device for calibration, the notch of the wafer may overlap with the gripper, which causes the comparison sensor to determine the position of the notch incorrectly. Therefore, in practice, the necessity of readjusting the position of the wafer often allows the notch and the gripper to be staggered with each other, thereby increasing the time for wafer calibration. In addition, when the thickness of the wafer is thin, the gripper causes irregular deformation and warping in the process of gripping, and misjudges the position of the notch easily.

### SUMMARY

The disclosure provides a wafer aligner which can efficiently identify a position of a notch of the wafer to achieve the required positioning and calibration effect.

A wafer aligner of the disclosure includes a platform, a lifting gripper, a rotating gripper, a rangefinder, and a control module. The lifting gripper is disposed on the platform to be lifted up or lowered down. The rotating gripper is disposed on the platform to be rotated. The lifting gripper and the rotating gripper are coaxial and alternately disposed with each other relative to the platform. The rangefinder is disposed next to the platform. The control module is electrically connected to the lifting gripper, the rotating gripper, and the rangefinder. The control module drives the lifting gripper to lift up relative to the platform, so that the wafer is transferred between the lifting gripper and the rotating gripper. When the wafer is located on the rotating gripper, the control module drives the rotating gripper to rotate relative to the platform, and drives the rangefinder to detect a change in a relative distance along an edge of the wafer to determine a position of a notch of the wafer.

Based on the above, the wafer aligner allows the wafer to be smoothly transferred between the lifting gripper and the rotating gripper by the alternation between the two. In particular, the lifting gripper is only used for wafer transfer, which is used to transfer the wafer to the rotating gripper or take out the wafer from the rotating gripper, so that the wafer only detects the notch above the rotating gripper.

More importantly, the wafer aligner detects the change in the relative distance to the edge of the wafer by the rangefinder. In other words, the change in the relative distance at the notch may be detected, and the position of the notch may be confirmed, so that the rotating gripper may further and accurately rotate the wafer to the predetermined position to facilitate subsequent processes. In this way, effectively avoids possible misjudgments caused by existing sensors can be effectively avoided. Especially when the notch of the wafer overlaps the clamp, the rangefinder can avoid the interference of the aforementioned situation and reduce the time of replacing the wafer, thereby improving the accuracy and efficiency of the sensing process.

### BRIEF DESCRIPTION OF THE DRAWINGS

FIG. 1 is a schematic view of a wafer placed on a wafer aligner according to an embodiment of the disclosure.
FIG. 2 is a schematic view of a wafer aligner.
FIG. 3 is a top view of the wafer aligner in FIG. 2.
FIG. 4 is an electrical connection view of relevant components in a wafer aligner.
FIG. 5 is a side view of the wafer aligner in FIG. 2.
FIG. 6 is a flowchart of a wafer aligner.
FIG. 7 is a partial simple schematic view of the wafer aligner in FIG. 2.

### DESCRIPTION OF THE EMBODIMENTS

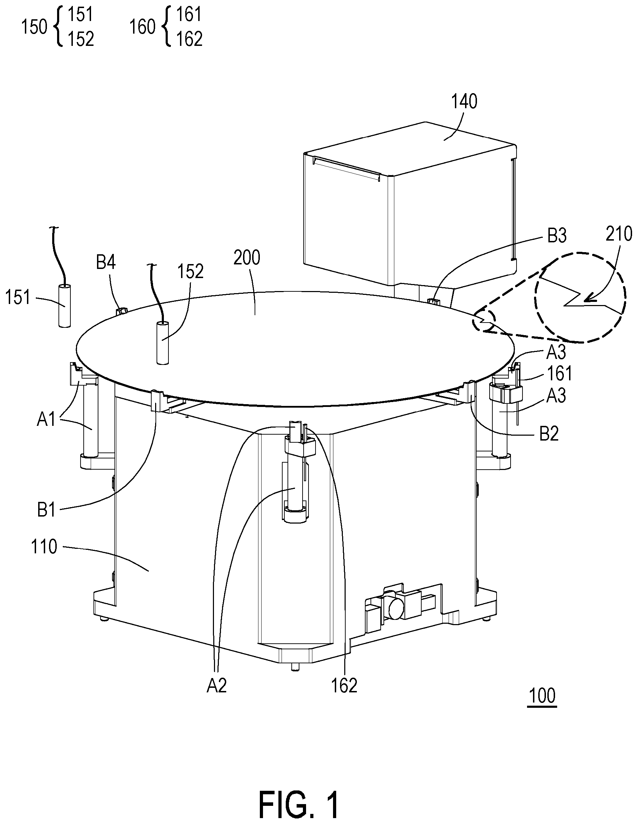

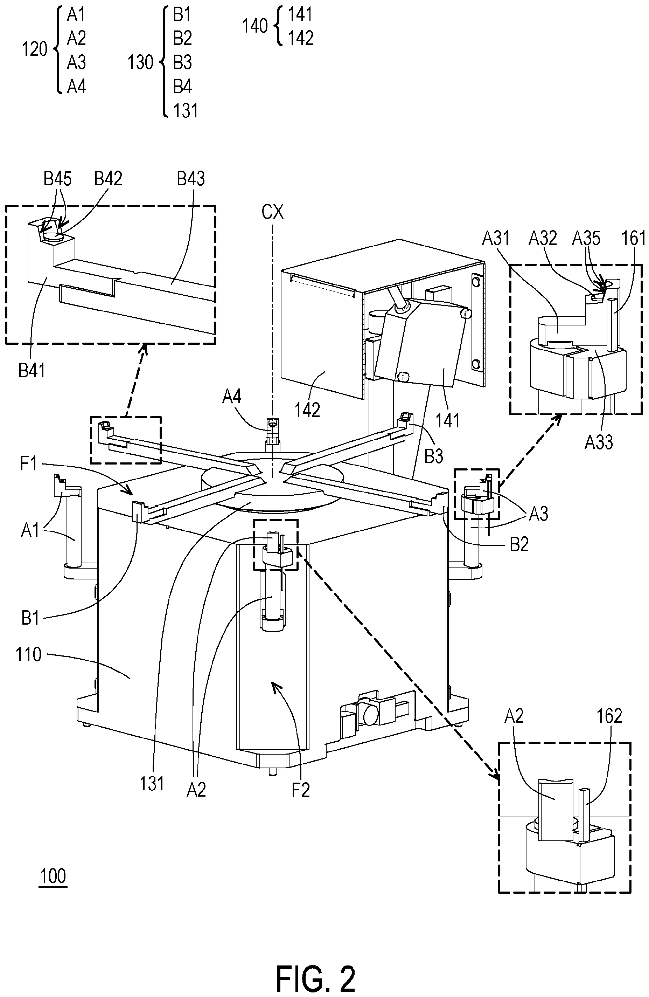

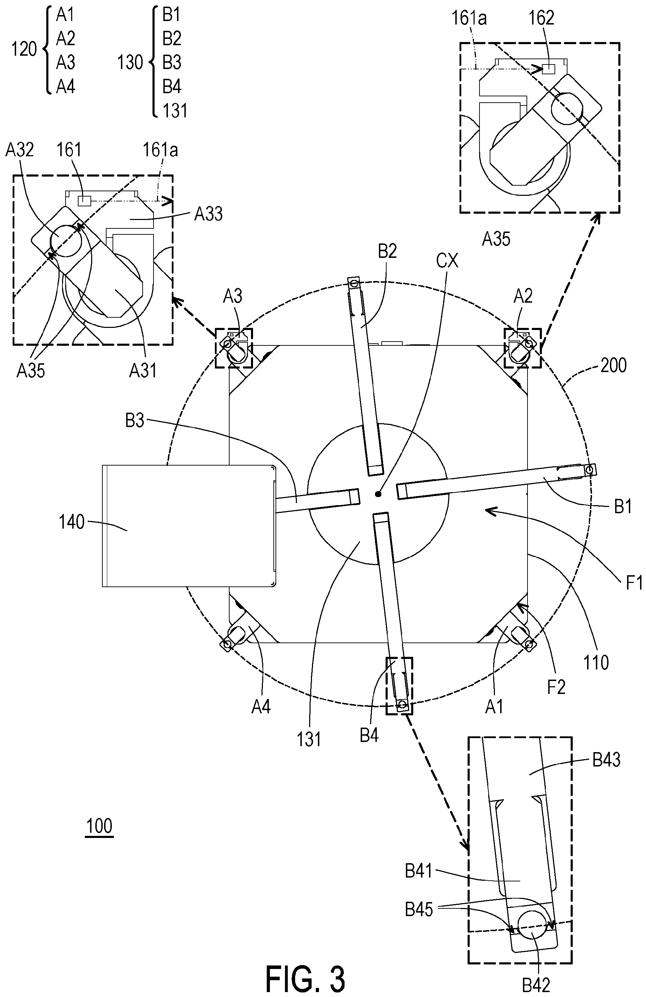

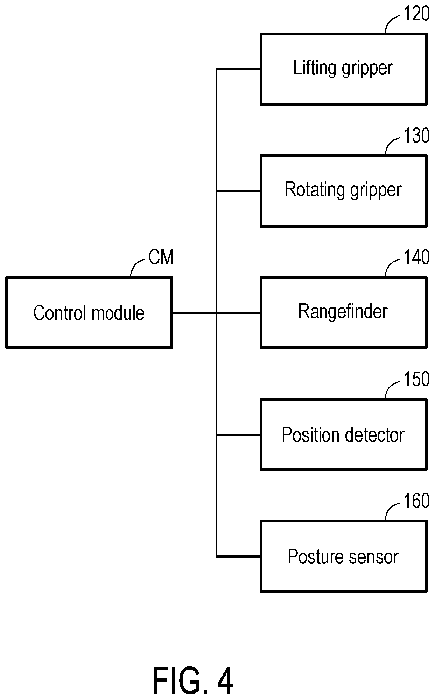

FIG. 1 is a schematic view of a wafer placed on a wafer aligner according to an embodiment of the disclosure. FIG. 2 is a schematic view of a wafer aligner. FIG. 3 is a top view of the wafer aligner in FIG. 2. FIG. 4 is an electrical connection view of relevant components in a wafer aligner. Please refer to FIG. 1, FIG. 2, and FIG. 4. In this embodiment, a wafer aligner 100 includes a platform 110, a lifting gripper 120, a rotating gripper 130, a rangefinder 140, and a position detector 150, and a control module CM. The lifting gripper 120 is disposed on a lateral surface F2 of the platform 110 to be lifted up or lowered down. The rotating gripper 130 is disposed on a top surface F1 of the platform 110 to be rotated. The lifting gripper 120 and the rotating gripper 130 are coaxial and alternately disposed with each other relative to a center shaft CX of the platform 110. The rangefinder 140 is disposed next to the platform 110 and includes a case 142 and a sensing unit 141 disposed in the case 142. As shown in FIG. 1, the position detector 150 includes a first detection unit 151 and a second detection unit 152 which are respectively disposed next to the platform 110. The first detection unit 151 is located next to the lifting gripper 120, and the second detection unit 152 is located above the rotating gripper 130.

The control module CM is electrically connected to the lifting gripper 120, the rotating gripper 130, the rangefinder 140, and the position detector 150 (the first detection unit 151 and the second detection unit 152 thereof). The control module CM drives the lifting gripper 120 to lift up and lower down relative to the platform 110 (that is, to move in a direction parallel to the center shaft CX), so that the wafer 200 is transferred between the lifting gripper 120 and the rotating gripper 130. When the wafer 200 is located on the rotating gripper 130, the control module CM drives the rotating gripper 130 to rotate relative to the platform 110 (the center shaft CX thereof), and drives the rangefinder 140 to detect a relative distance along an edge of the wafer 200. Accordingly, a position of a notch 210 of the wafer 200 is determined by a change in the relative distance.

Please refer to FIG. 2 and FIG. 3 again. Specifically, the lifting gripper 120 of this embodiment includes multiple first gripper units A1, A2, A3, and A4 (here, four are taken as an example) which are symmetrically disposed relative to the center shaft CX, and the rotating gripper 130 includes multiple second gripper units B1, B2, B3, and B4 (here, 4 are taken as an example) which are symmetrically disposed relative to the center shaft CX. The first gripper units A1 to A4 and the second gripper units B1 to B4 are staggered with each other. Furthermore, as shown in FIG. 3, a distance between the first gripper units A1 to A4 relative to the center shaft CX is equal to a distance between the second gripper units B1 to B4 relative to the center shaft CX, so that the lifting gripper 120 and the rotating gripper 130 may carry the wafer 200 of the same size respectively, where the distance relative to the center shaft CX represents a radius of the wafer 200 carried.

In addition, as shown in FIG. 2, taking the first gripper unit A3 of the lifting gripper 120 as an example (the other first gripper units A1, A2, and A4 are also composed of the same components and are not repeated), the first gripper unit A3 includes a retaining box A31, a rubbing sheet A32, a base A33, and inclined guide surfaces A35. The base A33 is disposed on the lateral surface F2 of the platform 110, the retaining box A31 is located on the base A33, the rubbing sheet A32 is disposed on the retaining box A31, and an upper protruding structure of the retaining box A31 has two inclined guide surfaces A35. When carried on the first gripper units A1 to A4 of the lifting gripper 120, the wafer 200 essentially makes the edge thereof bear on the retaining box A31 and a bottom surface thereof be in contact with the rubbing sheet A32 to keep the wafer 200 on the lifting gripper 120. The inclined guide surfaces A35 makes the edge of the wafer 200 to abut and provides a guiding and positioning effect when the wafer 200 falls into the lifting gripper 120.

As shown in FIG. 2, the rotating gripper 130 further includes a rotating base 131. The rotating base 131 is disposed on the top surface F1 of the platform 110 to be rotated along the center shaft CX of the platform 110. The aforementioned second gripper units B1 to B4 are respectively disposed on the rotating base 131 to rotate with the rotating base 131 relative to the platform 110. Similarly, the second gripper units B1 to B4 of the rotating gripper 130 also have components similar to the first gripper units A1 to A4. Here, taking the second gripper unit B4 as an example, the second gripper units B1 to B3 also have the same components and are not repeated. In this embodiment, the second gripper unit B4 includes a retaining box B41, a rubbing sheet B42, a base B43, and inclined guide surfaces B45. The base B43 extends radially from the rotating base 131 and is away from the center shaft CX, the retaining box B41 is located on an end of the base B43, the rubbing sheet B42 is disposed on the retaining box B41, and an upper protruding structure of the retaining box B41 has two inclined guide surfaces B45. The wafer 200 bears on the retaining box B41, so that the bottom surface thereof is in contact with the rubber sheet B42. The inclined guide surfaces B45 makes the edge of the wafer 200 to abut and provides a guiding and positioning effect when the wafer 200 falls into the rotating gripper 130.

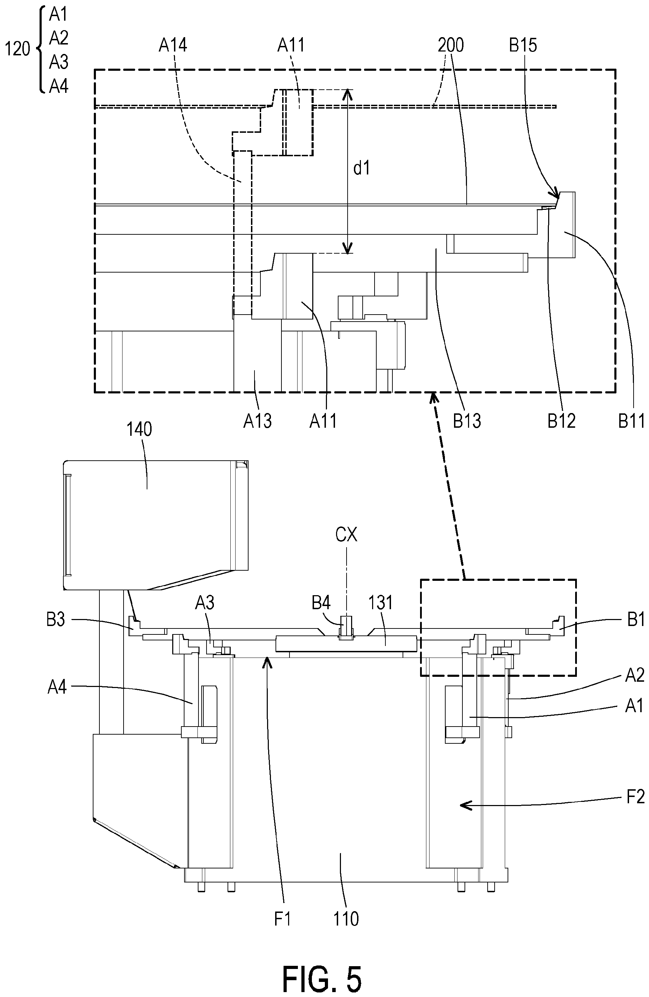

FIG. 5 is a side view of the wafer aligner in FIG. 2, in which the first gripper unit A1 of the lifting gripper 120 and the second gripper unit B1 of the rotating gripper 130 are partially enlarged, and a movement mode of the first gripper unit A1 is shown by a dotted line. Here, the first gripper unit A1 has a stroke d1, and a height of the second gripper unit B1 is located between the stroke d1 relative to the platform 110. In this way, the wafer 200 may be smoothly and effectively transferred to the rotating gripper 130 or taken out from the rotating gripper 130 when the lifting gripper 120 is lifted up.

Here, the first gripper unit A1 further includes a telescopic member A14 which is disposed on the lateral surface F2 of the platform 110, and a telescopic direction of the telescopic member A14 is parallel to the center shaft CX. The retaining box A11 is disposed on the telescopic member A14 to be lifted up and lowered down according to the telescopic movement of the telescopic member A14 and relative to the base A13 disposed on the platform 110. Accordingly, when the retaining box A11 is lowered down by the telescopic member A14, the wafer 200 originally placed on the lifting gripper 120 may be changed to bear on the second gripper unit B1 of the rotating gripper 130 just as the lifting gripper 120 passes the second gripper unit B1 of the rotating gripper 130. Here, the second gripper unit B1 also includes a base B13, a retaining box B11, and a rubbing sheet B12. The retaining box B11 bears against an end of the base B13, the rubbing sheet B12 is disposed on the retaining box B11, and a side edge of the wafer 200 abuts an inclined guide surface B15 and smoothly falls on the rubbing sheet B12 after the aforementioned wafer 200 is transferred from the first gripper unit A1 to the second gripper unit B1. On the contrary, when the retaining box A11 is lifted up by the telescopic member A14, the wafer 200 may be pushed upward and taken out from the rotating gripper 130, which allows the wafer 200 of the disclosure to be carried alternately by the lifting gripper 120 and the rotating gripper 130 to avoid the possibility of bending and deformation of the wafer 200 caused by being continuously clamped by a single clamp.

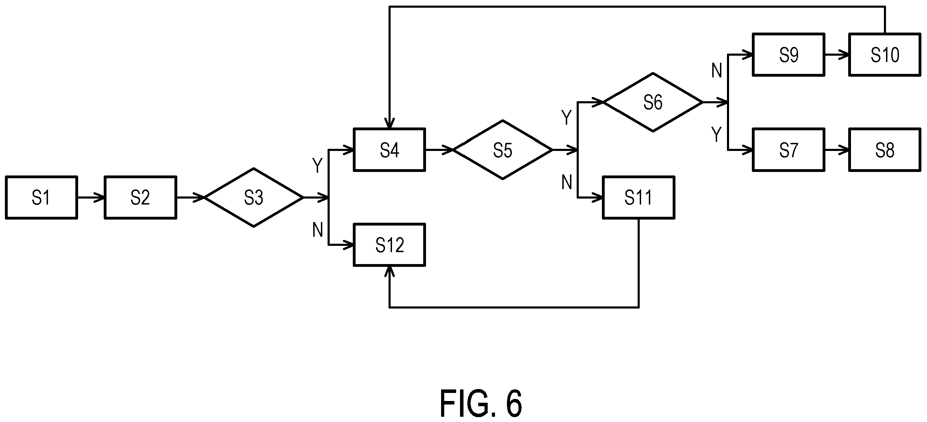

FIG. 6 is a flowchart of a wafer aligner. Please refer to FIG. 6 and compare FIG. 6 to the aforementioned FIG. 1 to FIG. 5 respectively, so as to clearly understand the positioning process of the wafer 200 performed by the wafer aligner 100. Here, a symbol Y in the figure represents affirmation, and a symbol N represents negation.

First, in Step S1, the lifting gripper 120 is driven by the control module CM to be positioned in the transfer position. Please refer to FIG. 5. The transfer position is equivalent to a position of the first gripper unit A1 (the retaining box A11 thereof) shown by the dotted line to facilitate the movement of the wafer 200 in or out. Next, in Step S2, the wafer 200 is placed into the lifting gripper 120, as shown by the dotted line in the figure. Next, in Step S3, the control module CM detects the lifting gripper 120 by the first detection unit 151 (as shown in FIG. 1) to confirm that the wafer 200 is correctly carried by the lifting gripper 120. At this time, if the first detection unit 151 detects that the wafer 200 is not placed into the lifting gripper 120, Step S12 is executed. That is, the wafer aligner 100 is stopped until the wafer 200 is indeed placed into the lifting gripper 120. It should be noted that there is no limitation on the upper device for placing the wafer 200 into the lifting gripper 120.

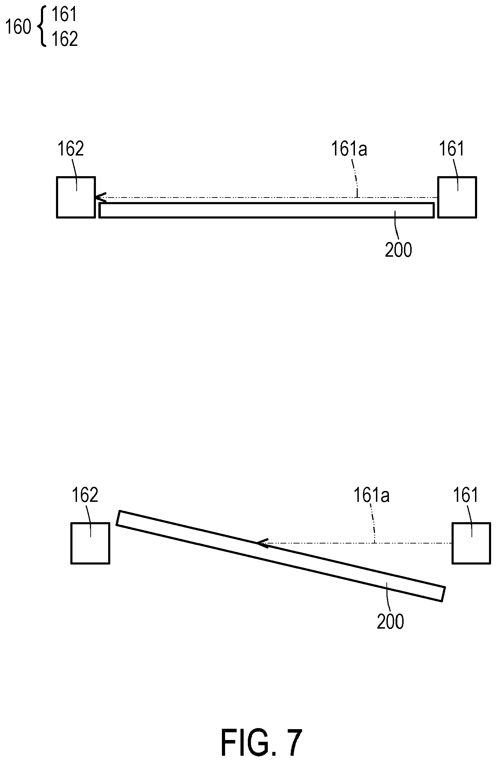

In addition, it should be mentioned that in Step S3, in addition to using the first detection unit 151 to confirm whether the wafer 200 is in position, the in-position posture of the wafer 200 may also be further confirmed. FIG. 7 is a partial simple schematic view of the wafer aligner in FIG. 2, which is only shown from a side perspective. Please refer to any one of FIG. 2 to FIG. 4, and FIG. 7. In this embodiment, the wafer aligner 100 further includes a posture sensor 160 electrically connected to the control module CM. The posture sensor 160 includes a light-emitting unit 161 and a receiving unit 162. The light-emitting unit 161 is disposed next to one of the first gripper units (the first gripper unit A3 is taken as an example here, but is not limited thereto). The receiving unit 162 is disposed next to another one of the first gripper units (the first gripper unit A2 is taken as an example here, but not limited to thereto). The light-emitting unit 161 provides a beam 161a (as shown in FIG. 3 and FIG. 7) for projection to the receiving unit 162. The control module CM determines the posture of the wafer 200 on the lifting gripper 120 based on whether the receiving unit 162 receives the beam 161a.

As shown in the upper figure in FIG. 7, the receiving unit 162 successfully receives the beam 161a provided by the light-emitting unit 161, which means that the wafer 200 is carried horizontally on the lifting gripper 120 at this time. In other words, the beam 161a provided by the light-emitting unit 161 is horizontal, and the beam 161a may smoothly travel along the upper surface of the wafer 200 until being received by the receiving unit 162 if the wafer 200 is also horizontal. On the contrary, as shown in the lower figure in FIG. 7, since the posture of the wafer 200 has blocked the movement of the beam 161a, the wafer 200 is obviously not smoothly carried on the lifting gripper 120, which is considered that the wafer 200 is not located on the lifting gripper 120, and Step S12 needs to be executed as mentioned above.

Next, after Step S3 indeed detects that the wafer 200 has been placed into the lifting gripper 120, Step S4 is executed. The control module CM drives the lifting gripper 120 to lower down. That is, the lifting gripper 120 shown in FIG. 5 reaches the position shown by the solid line from the position shown by the dotted line after lowering the stroke d1. Since the rotating gripper 130 is located between the stroke d1 of the lifting gripper 120, the wafer 200 is smoothly transferred from the lifting gripper 120 to the rotating gripper 130. Next, as shown in Step S5, the control module CM detects whether the wafer 200 has successfully fallen into the rotating gripper 130 by the second detection unit 152 (as shown in FIG. 1). If the second detection unit 152 does not detect that the wafer 200 falls into the rotating gripper 130, Steps S11 and S12 are executed in sequence. That is, the control module CM first lifts the lifting gripper 120 to the initial position (in Step S11, the lifting gripper 120 returns to the position shown by the dotted line in FIG. 5). Then, Step S12 is executed, that is, the wafer aligner 100 is stopped, waiting for the wafer 200 to be firmly placed into the lifting gripper 120.

On the contrary, if the wafer 200 is confirmed to be placed into the rotating gripper 130, Step S6 is executed in continuation. That is, the control module CM drives the rotating gripper 130 to rotate the wafer 200, and drives the rangefinder 140 to detect the edge of the wafer 200 at the same time to detect the presence or absence of the notch 210 of the wafer 200 by the change in the relative distance. Then, if the notch 210 of the wafer 200 is detected, the control module CM executes Step S7 to rotate the wafer 200 to a specific position, and then executes Step S9. The control module CM drives the lifting gripper 120 to lift up to transfer the wafer 200 from the rotating gripper 130 to the lifting gripper 120, so that the lifting gripper 120 is lifted up to the transfer position, as shown by the dotted line in FIG. 5, waiting for the upper device to take out the wafer 200. Similarly, the upper device is not limited here.

On the contrary, if the rangefinder 140 does not detect the notch 210 of the wafer 200, the wafer 200 may be placed at the position of the rotating gripper 130, which causes an error that may not be detected by the second detection unit 152. Thus, Steps S9 and S10 are executed in continuation. In Step S9, the control module CM drives the lifting gripper 120 to lift up, so that the wafer 200 is transferred from the rotating gripper 130 to the lifting gripper 120. Then, in Step S10, the control module CM drives the rotating gripper 130 to rotate to change the relative position to the lifting gripper 120 and the wafer 200 thereon. Next, Step S4 is executed again, that is, the lifting gripper 120 is driven to lower down again, and the wafer 200 is placed into the rotating gripper 130 again, and then the Steps are executed in continuation as described above. At this point, the wafer aligner 100 may successfully obtain the position of the notch 210 of the wafer 200 with the rangefinder 140 by the cooperation of the rotating gripper 130 and the lifting gripper 120, and accordingly rotate the wafer 200 to the specific position to facilitate subsequent processes.

To sum up, in the aforementioned embodiments of the disclosure, the wafer aligner allows the wafer to be smoothly transferred between the lifting gripper and the rotating gripper by the alternation between the two. In particular, the lifting gripper is only used for wafer transfer, which is used to transfer the wafer to the rotating gripper or take out the wafer from the rotating gripper, so that the wafer only detects the notch above the rotating gripper. Furthermore, the above alternation allows the wafer to naturally fall into the center of the lifting gripper or the rotating gripper, which is beneficial to the position maintenance and center positioning of the wafer. In addition, the telescopic characteristics of the clamp can also increase the applicable range of the wafer.

More importantly, the wafer aligner detects the change in the relative distance to the edge of the wafer by the rangefinder. In other words, the change in the relative distance at the notch may be detected, and the position of the notch may be confirmed, so that the rotating gripper may further and accurately rotate the wafer to the predetermined position to facilitate subsequent processes. In this way, effectively avoids possible misjudgments caused by existing sensors can be effectively avoided. Especially when the notch of the wafer overlaps the clamp, the rangefinder can avoid the interference of the aforementioned situation and reduce the time of replacing the wafer, thereby improving the accuracy and efficiency of the sensing process.

## Claims

1. A wafer aligner (100), comprising:
a platform (110);
a lifting gripper (120), disposed on the platform (110) to be lifted up or lowered down;
a rotating gripper (130), disposed on the platform (110) to be rotated, wherein the lifting gripper (120) and the rotating gripper (130) are coaxial and alternately disposed with each other relative to the platform (110);
a rangefinder (140), disposed next to the platform (110); and
a control module (CM), electrically connected to the lifting gripper (120), the rotating gripper (130), and the rangefinder (140),
wherein the control module (CM) drives the lifting gripper (120) to lift up relative to the platform (110), so that a wafer (200) is transferred between the lifting gripper (120) and the rotating gripper (130), and
wherein when the wafer (200) is located on the rotating gripper (130), the control module (CM) drives the rotating gripper (130) to rotate relative to the platform (110), and drives the rangefinder (140) to detect a change in a relative distance along an edge of the wafer (200) to determine a position of a notch (210) of the wafer (200).

2. The wafer aligner (100) according to claim 1, further comprising a position detector (150) disposed next to the platform (110) and electrically connected to the control module (CM), wherein the control module (CM) determines whether the wafer (200) is located on the lifting gripper (120) or on the rotating gripper (130) by the position detector (150).

3. The wafer aligner (100) according to claim 2, wherein the position detector (150) comprises a first detection unit (151) and a second detection unit (152) electrically connected to the control module (CM) respectively, wherein the first detection unit (151) is located next to the lifting gripper (120), and the second detection unit (152) is located above the rotating gripper (130).

4. The wafer aligner (100) according to claim 1, wherein the platform (110) has a center shaft (CX), a plurality of first gripper units (A1, A2, A3, and A4) of the lifting gripper (120) are symmetrically disposed relative to the center shaft (CX), and a plurality of second gripper units (B1, B2, B3, and B4) of the rotating gripper (130) are symmetrically disposed relative to the center shaft (CX), and the first gripper units (A1, A2, A3, and A4) and the second gripper units (B1, B2, B3, and B4) are staggered with each other.

5. The wafer aligner (100) according to claim 4, wherein a distance of the first gripper unit (A1, A2, A3, and A4) relative to the center shaft (CX) is equal to a distance of the second gripper unit (B1, B2, B3, and B4) relative to the center shaft (CX).

6. The wafer aligner (100) according to claim 4, wherein the first gripper unit (B1, B2, B3, and B4) and the second gripper unit (B1, B2, B3, and B4) include a retaining box (A11, A31, B11, B41) and a rubbing sheet (A32, B12, and B42) respectively, the retaining box (A11, A31, B11, B41) has an inclined guide surface (A35, B15, and B45), the rubbing sheet (A32, B12, and B42) is disposed on the retaining box (A11, A31, B11, B41), and the wafer (200) abuts an edge of the wafer (200) and is guided by the inclined guide surface (A35, B15, and B45), so that the wafer (200) falls into the retaining box (A11, A31, B11, B41) and is in contact with the rubbing sheet (A32, B12, and B42).

7. The wafer aligner (100) according to claim 4, wherein the first gripper unit (B1, B2, B3, and B4) comprises a retaining box (A11, A31, B11, B41) and a telescopic member (A14), the telescopic member (A14) is disposed on a lateral surface of the platform (110), a telescopic direction of the telescopic member (A14) is parallel to the center shaft (CX), the retaining box (A11, A31, B11, B41) is disposed on the telescopic member (A14) to be lifted up or lowered down according to a telescopic movement of the telescopic member (A14) and relative to the platform (110).

8. The wafer aligner (100) according to claim 1, wherein the rotating gripper (130) is located between a stroke (d1) of the lifting gripper (120) relative to the platform (110) at a height of the platform (110).

9. The wafer aligner (100) according to claim 1, wherein the rotating gripper (130) comprises a rotating base (131) and a plurality of second gripper units (B1, B2, B3, and B4), the rotating base (131) is disposed on the platform (110) to be rotated along a center shaft (CX) of the platform (110), and the plurality of second gripper units (B1, B2, B3, and B4) are disposed on the rotating base (131) to rotate with the rotating base (131) relative to the platform (110).

10. The wafer aligner (100) according to claim 4, further comprising an posture sensor (160) electrically connected to the control module (CM), wherein the posture sensor (160) comprises a light-emitting unit (161) and a receiving unit (162), the light-emitting unit (161) is disposed next to one of the plurality of first gripper units (A1, A2, A3, and A4), the receiving unit (162) is disposed next to another one of the plurality of first gripper units (A1, A2, A3, and A4), the light-emitting unit (161) provides a beam (161a) for projection to the receiving unit (162), and the control module (CM) determines a posture of the wafer (200) on the rotating gripper (130) based on whether the receiving unit (162) receives the beam (161a).
